# EUROPEAN PATENT APPLICATION

(11) **EP 1 548 801 A1**
(43) Date of publication of application: **29.06.2005**
(21) Application number: 03792633.4
(22) Date of filing: 23.07.2003
(51) Int. Cl.: H01L 21/02, H01L 21/304, H01L 21/306

(54) **METHOD FOR FABRICATING SEMICONDUCTOR WAFER**

(30) Priority: 21.08.2002 JP 2002240578
(71) Applicant: Disco Corporation, Tokyo 143-8580 (JP)
(72) Inventor: ARAI, Kazuhisa, DISCO CORPORATION, Ota-ku, Tokyo 144-0033 (JP)
(74) Representative: VOSSIUS & PARTNER
(86) International application number: PCT/JP2003/009338
(87) International publication number: WO 2004/019388

(57) **Abstract**

A supporting substrate (10) having a flat supporting face is integrated with a semiconductor wafer W while supporting the surface thereof on the supporting face of the supporting substrate (10). The semiconductor wafer W integrated with the supporting substrate (10) is polished or etched on the back thereof using a thinning device and a film is formed on the back of the semiconductor wafer W integrated with the supporting substrate (10) using a film forming device (40). Since the semiconductor wafer W is integrated with the supporting substrate, even a semiconductor wafer as thin as 100 µm or less is not warped and thereby the film can be formed uniformly.

## Description

### TECHNICAL FIELD

The present invention relates to a method for fabricating a semiconductor wafer to be formed with a film on the back surface thereof.

### BACKGROUND ART

As the structures of semiconductor chips have been thinned in recent years, laminated chips in each of which semiconductor chips are stacked one over the other to enhance a function, a processability, a storage capacity, etc. have been put into practical use. Thus, it has become possible to make a cellular phone, a laptop computer, etc. thin in structure, small in size and light in weight.

In the fabrication of the laminated chip, at the stage of a semiconductor wafer, electrodes extending from a front surface formed with circuits to a back surface are embedded, and the electrodes are exposed by subjecting the back surface to mechanical polishing or chemical etching. Also, an insulating film such as SiO₂ film is formed on the back surface of the semiconductor wafer in order to prevent the electrodes formed with metal such as copper or the like from diffusing into the semiconductor of silicon or the like.

Besides, there has been put into practical use a technique to construct a semiconductor wafer in such a way that, after the circuits of power transistors etc. have been formed in the front surface of the semiconductor wafer, the back surface of the semiconductor wafer is polished or etched, whereupon a metal film of Ti, Ag, Au or the like is formed on the resulting back surface to a thickness of several tens nm.

In such a case where the semiconductor wafer formed with the circuits on the front surface thereof has its back surface thinned by the polishing or the like and where the film is thereafter formed on the resulting back surface, this semiconductor wafer needs to be formed as thin as possible for the purpose of attaining good thermal and electric characteristics for semiconductor chips.

However, when the thickness of the semiconductor wafer is made, for example, 100 µm - 15 µm or so, the semiconductor wafer warps to hinder the formation of the film, resulting in the problem that the film cannot be uniformly formed.

In particular, when a reduced-pressure film-forming device having film-forming means to form a film in a reduced-pressure environment is employed to form the film, a suction force cannot be used in a holding table for holding the semiconductor wafer, and the semiconductor wafer is held in electrostatic fashion as a result. Therefore, the stress of the film warps the semiconductor wafer against the holding force of the holding table of electrostatic type, and the film fails to be uniformly formed.

Accordingly, in order to endow the semiconductor wafer with a rigidity to the extent of avoiding the warp, a limitation of about 200 µm is imposed on the thickness of the semiconductor wafer in the present situation, resulting in the problem that the semiconductor wafer cannot be formed thinner than the limitation.

The present invention has been made in view of such circumstances, and has for its object to realize the formation of a uniform film even when a semiconductor wafer has been made thinner in the case of forming the film on the back surface of the semiconductor wafer.

### DISCLOSURE OF INVENTION

As a concrete expedient for accomplishing the object, the present invention provides a method for fabricating a semiconductor wafer, wherein the semiconductor wafer formed with circuits in its front surface is formed with a film on its back surface, comprising at least an integration step of integrating a supporting substrate and the semiconductor wafer by supporting the front surface of the semiconductor wafer on a flat supporting face of the supporting substrate; a thinning step of uniformly removing the back surface of the semiconductor wafer integrated with the supporting substrate by employing a thinning device for processing the semiconductor wafer to be thin, thereby to thin the semiconductor wafer; and a film formation step of forming a film on the back surface of the semiconductor wafer integrated with the supporting substrate by employing a film forming device.

Besides, the method for fabricating a semiconductor wafer may well comprise as its additional requisites the fact that the thinning device includes at least one chuck table for holding the semiconductor wafer thereon, and thinning means for acting on the semiconductor wafer held on the chuck table, and that the thinning step is carried out by holding the supporting substrate integrated with the semiconductor wafer on the chuck table, and causing the thinning means to act on the back surface of the semiconductor wafer; the fact that the film forming device includes a holding portion for holding the semiconductor wafer thereon, and film forming means for forming the film on the back surface of the semiconductor wafer held on the holding portion, and that the film is formed on the back surface of the semiconductor wafer by the film forming means with the supporting substrate integrated with the thinned semiconductor wafer, held on the holding portion; the fact that the thinning device is a polishing device including polishing means as the thinning means; the fact that the film forming device is a reduced-pressure film forming device in which the film forming means forms the film in a reduced-pressure environment; the fact that wherein the supporting substrate is a glass substrate, and that the semiconductor wafer is processed to a thickness of 100 µm - 15 µm at the thinning step; the fact that the glass substrate has a thickness of 1 mm - 3 mm; and the fact that the semiconductor wafer is stuck to the supporting substrate through an adhesive containing a resin.

According to the method for fabricating a semiconductor wafer as is thus constructed, the film formation step is carried out in the state where the semiconductor wafer is supported by the supporting substrate of high rigidity, so that even when the semiconductor wafer has been processed as very thin as 100 µm or less at the thinning step, the film can be formed without the warp of the semiconductor wafer.

### BRIEF DESCRIPTION OF DRAWINGS

Fig. 1 is a perspective view showing an example of a semiconductor wafer to which the present invention is to be applied.
Fig. 2 is a perspective view showing an example of a supporting substrate to be integrated with the semiconductor wafer.
Fig. 3 is a perspective view showing a state where the semiconductor wafer and the supporting substrate have been integrated.
Fig. 4 is a perspective view showing an example of a polishing device to be employed for a thinning step constituting the invention.
Fig. 5 is a schematic sectional view showing an example of a reduced-pressure film-forming device to be employed for a film formation step constituting the invention.

### BEST MODE FOR CARRYING OUT THE INVENTION

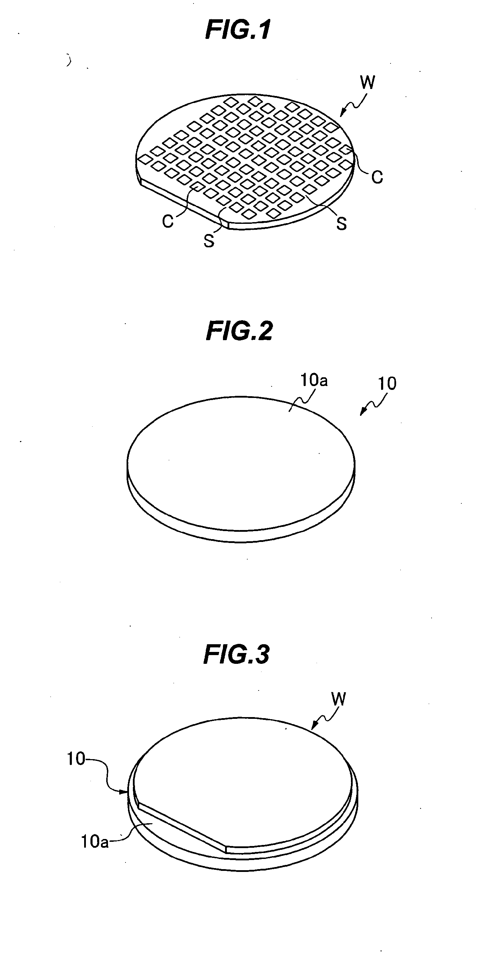

As an embodiment of the present invention, there will be described a case where the back surface of a semiconductor wafer W shown in Fig. 1 is polished or etched and where a film is thereafter formed. On the front surface of the semiconductor wafer W, a plurality of streets S are formed in a lattice shape at predetermined intervals, and circuit patterns are formed in a large number of rectangular regions demarcated by the streets S. Besides, the individual rectangular regions are made semiconductor chips C by cutting the streets S.

The semiconductor wafer W is integrated with a supporting substrate 10 shown in Fig. 2, before polishing the back surface of this semiconductor wafer and forming the film thereon. The supporting substrate 10 is constructed of a member of high rigidity so that the semiconductor wafer made as very thin as 100 µm or less by the polishing can be stably supported without warping. A substrate of glass, for example, can be employed as the supporting substrate 10. Also, ceramics, an alloy, a metal, a resin, or the like can be employed instead of the glass. In case of employing the glass substrate, the thickness thereof should desirably be 1 mm - 3 mm or so.

The front surface 10a of the supporting substrate 10 as a supporting face, and the back surface thereof are formed flat. As shown in Fig. 3, the supporting substrate 10 and the semiconductor wafer W are stuck and integrated by an adhesive so that the front surface 10a of the former and the front surface of the latter may confront each other, whereby the semiconductor wafer W is supported on the front surface 10a (integration step). In this state, that back surface of the semiconductor wafer W in which no circuit is formed is exposed.

The adhesive should favorably be one made of a resin such as of acryl type, ester type or urethane type. Besides, in the case of employing the glass substrate as the supporting substrate 10, when an adhesive of the type whose bonding strength is lowered by ultraviolet radiation is used, the adhesive can be irradiated with the ultraviolet radiation through the glass substrate later, and hence, the supporting substrate 10 and the semiconductor wafer W can be easily separated.

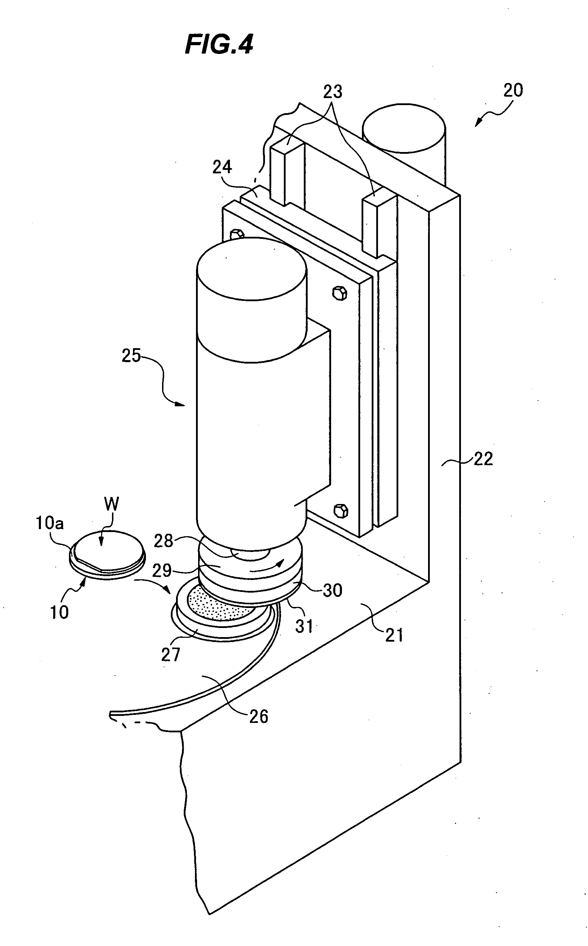

Subsequently, a thinning work is performed by polishing the back surface of the semiconductor wafer W supported by the supporting substrate 10 as described above. An appropriate thinning device, for example, a polishing device 20 shown in Fig. 4, can be used for the thinning work.

In the polishing device 20, a pair of rails 23 are disposed in the vertical direction on the inside surface of a wall portion 22 erected from an end part of a bed 21. Polishing means 25 being thinning means, which is attached to a support plate 24, is adapted to move up or down as the support plate 24 ascends or descends along the rails 23. Besides, a turntable 26 is rotatably disposed over the bed 21. Further, a plurality of chuck tables 27 each holding the object to-be-polished is rotatably disposed on the turntable 26.

In the polishing means 25, a polishing wheel 30 is set through a mounter 29 at the distal end of a spindle 28 having a vertical axis. A polishing grindstone 31 is secured onto the lower surface of the polishing wheel 30, and it is rotated with the rotation of the spindle 28.

The semiconductor wafer W integrated with the supporting substrate 10 is supported in such a way that the back surface of the supporting substrate 10 is held on the chuck table 27. This semiconductor wafer W is located directly under the polishing means 25 by the rotation of the turntable 26, and it is held in opposition to the polishing grindstone 31 in a state where its back surface looks upward.

Herein, the polishing means 25 descends while rotating the polishing grindstone 31, and it acts on the back surface of the semiconductor wafer W and exerts a thrust pressure thereon, whereby the back surface is ground. The back surface is removed a predetermined amount by performing such polishing the predetermined amount, and the semiconductor wafer W is thinned to a desired thickness, for example, a thickness of 100 µm - 15 µm (thinning step). Incidentally, apart from the polishing device 20, a dry etching device, a wet etching device or the like can also be employed as the thinning device. Besides, the polishing device and the etching device may well be combined for the purpose of permitting the polished surface to be etched after the polishing operation.

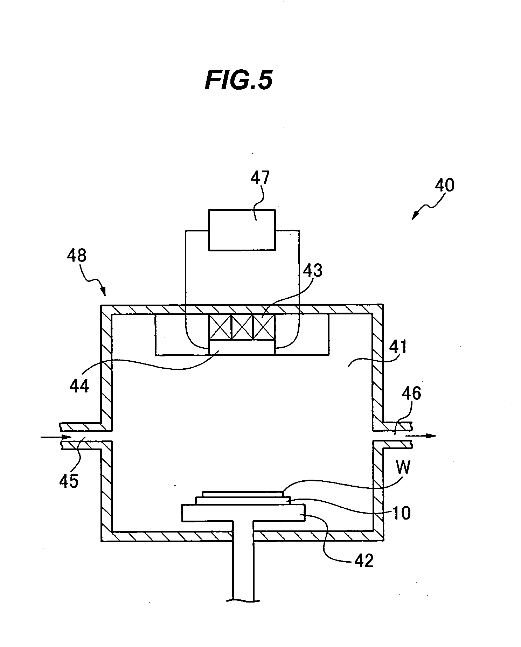

Subsequently, a film is formed on the back surface of the thinned semiconductor wafer W by employing an appropriate film-forming device. A PVD (Physical Vapor Deposition) device or a CVD (Chemical Vapor Deposition) device can be employed as film forming means. The case of using a reduced-pressure film-forming device 40 shown in Fig. 5 will be described below.

In the reduced-pressure film forming device 40, a holding portion 42 for holding a flat object in electrostatic fashion is disposed within a sputtering chamber 41, and a sputtering source 44 is disposed at the upper position of this device 40 opposing to the holding portion 42 in a state being supported by an excitation member 43. A high-frequency power source 47 is connected across the sputtering source 44. Besides, an introduction port 45 for introducing a sputtering gas is provided in one side part of the sputtering chamber 41, while a pressure reduction port 46 communicating with a pressure reduction source is provided in the other side part. Herein, the sputtering chamber 41, excitation member 43, sputtering source 44, introduction port 45, pressure reduction port 46 and high-frequency power source 47 constitute the film forming means 48.

The back surface of the supporting substrate 10 integrated with the semiconductor wafer W is held on the holding portion 42, whereby the back surface of the semiconductor wafer W is held in opposition to the sputtering source 44. Besides, the sputtering source 44 magnetized by the excitation member 43 is fed with high-frequency power of about 40 kHz by the high-frequency power source 47, the interior of the sputtering chamber 41 has its pressure reduced on the order of 10⁻² Pa - 10⁻⁴ Pa through the pressure reduction port 46 so as to establish a reduced-pressure environment, and argon gas is introduced through the introduction port 45 so as to generate a plasma. Then, argon ions in the plasma collide against the sputtering source 44 and drive out particles, which are deposited on the back surface of the semiconductor wafer W so as to form a film (film formation step).

During the formation of the film as proceeds in the above way, the interior of the sputtering chamber 41 is held in the state close to vacuum, and the semiconductor wafer W cannot be held on the holding portion 42 by suction, so that the semiconductor wafer W is electrostatically held. In this regard, when the thinned semiconductor wafer W is directly held on the holding portion 42 of the electrostatic type, a holding force is weaker than in case of a suction type, and hence, the thinned semiconductor wafer W warps.

In contrast, according to the invention, the semiconductor wafer W integrated with the supporting substrate 10 can be held through this supporting substrate of high rigidity undergoing no warp. Therefore, even the semiconductor wafer W formed to the thickness of 100 µm - 15 µm or so by the thinning work does not warp. Accordingly, the uniform film can be formed on the back surface of the semiconductor wafer W at high precision.

### INDUSTRIAL APPLICABILITY

As described above, in accordance with a method for fabricating a semiconductor wafer according to the present invention, a film formation step is carried out in a state where the semiconductor wafer is supported by a supporting substrate of high rigidity, so that even the semiconductor wafer processed to be as very thin as 100 µm or less at a thinning step does not warp. Accordingly, a uniform film can be formed even on the back surface of the very thin semiconductor wafer, and it is permitted to make the structure of the semiconductor wafer thin still further. Especially in a case where the film formation step is performed in a reduced-pressure environment, there is brought forth the advantage that the film can be formed without warping, although the semiconductor wafer cannot be held by suction.

## Claims

1. A method for fabricating a semiconductor wafer, wherein the semiconductor wafer formed with circuits in its front surface is formed with a film on its back surface, comprising at least:
an integration step of integrating a supporting substrate and the semiconductor wafer by supporting the front surface of the semiconductor wafer on a flat supporting face of the supporting substrate;
a thinning step of uniformly removing the back surface of the semiconductor wafer integrated with the supporting substrate by employing a thinning device for processing the semiconductor wafer to be thin, thereby to thin the semiconductor wafer; and
a film formation step of forming a film on the back surface of the semiconductor wafer integrated with the supporting substrate by employing a film-forming device.

2. A method for fabricating a semiconductor wafer according to claim 1, wherein:
the thinning device includes at least one chuck table for holding the semiconductor wafer thereon, and thinning means for acting on the semiconductor wafer held on the chuck table; and
said thinning step is carried out by holding the supporting substrate integrated with the semiconductor wafer on the chuck table, and causing the thinning means to act on the back surface of the semiconductor wafer.

3. A method for fabricating a semiconductor wafer according to claim 1, wherein:
the film forming device includes a holding portion for holding the semiconductor wafer thereon, and film forming means for forming the film on the back surface of the semiconductor wafer held on the holding portion; and
the film is formed on the back surface of the semiconductor wafer by the film forming means with the supporting substrate integrated with the thinned semiconductor wafer, held on the holding portion.

4. A method for fabricating a semiconductor wafer according to claim 2, wherein the thinning device is a polishing device including polishing means as the thinning means.

5. A method for fabricating a semiconductor wafer according to claim 3, wherein the film forming device is a reduced-pressure film forming device in which the film forming means forms the film in a reduced-pressure environment.

6. A method for fabricating a semiconductor wafer according to claim 1, wherein the supporting substrate is a glass substrate, and the semiconductor wafer is processed to a thickness of 100 µm - 15 µm at said thinning step.

7. A method for fabricating a semiconductor wafer according to claim 6, wherein the glass substrate has a thickness of 1 mm - 3 mm.

8. A method for fabricating a semiconductor wafer according to claim 1, wherein the semiconductor wafer is stuck to the supporting substrate through an adhesive containing a resin.
